Europäisches Patentamt

European Patent Office

Office européen des brevets

(19)

(11) Veröffentlichungsnummer: **0 098 670**
**A2**

(12) **EUROPÄISCHE PATENTANMELDUNG**

(21) Anmeldenummer: 83201006.0

(22) Anmeldetag: 06.07.83

(51) Int. Cl.³: **H 03 G 3/30**

(30) Priorität: 08.07.82 AT 2663/82

(43) Veröffentlichungstag der Anmeldung: 18.01.84
Patentblatt 84/3

(84) Benannte Vertragsstaaten: **DE FR GB**

(71) Anmelder: **N.V. Philips' Gloeilampenfabrieken,
Groenewoudseweg 1, NL-5621 BA Eindhoven (NL)**

(72) Erfinder: **Hasler, Rudolf, c/o INT. OCTROOIBUREAU B.V.
Prof. Holstlaan 6, NL-5656 AA Eindhoven (NL)**

(74) Vertreter: **Schoonheijm, Harry Barend et al,
INTERNATIONAAL OCTROOIBUREAU B.V.
Prof.Holstlaan 6, NL-5656 AA Eindhoven (NL)**

(54) "Tuner".

(57) Bei einem Tuner mit einer Hochfrequenzvorstufe (1) und einer mit einem Oszillatorsignal gespeisten Mischstufe (2, die durch einen Transistor (12) gebildet ist , der in seinem Emitterkreis einen Emitterwiderstand (13) aufweist, wird das Hochfrequenzsignal vom Ausgang der Hochfrequenzvorstufe dem Eingang der Mischstufe über eine gleichstrommässig vorgespannte Diode (28) zugeführt, wobei der Gleichstromweg für die Diode über den Emitterwiderstand der Mischstufe geführt ist und die über denselben fliessenden Ströme des Transistors und der Diode gleiche Flussrichtung aufweisen. Die Vorspannung der Diode wird über einen Regelkreis (30) in Abhängigkeit der Amplitude des unbegrenzten Zwischenfrequenzsignals geändert, wobei bei zunehmender Amplitude desselben der Gleichstrom durch die Diode sinkt.

"Tuner".

Die Erfindung betrifft einen Tuner mit einer Hochfrequenzvorstufe, von deren Ausgang das Hochfrequenzsignal einem Eingang einer Mischstufe zugeführt wird, der zusätzlich ein Oszillatorsignal eines Oszillators zugeführt wird und die durch einen Transistor gebildet ist, der in seinem Emitterkreis einen Emitterwiderstand aufweist und von dessen Kollektorkreis das Zwischenfrequenzsignal ausgekoppelt wird. Derartige Tuner sind von im Handel befindlichen, insbesondere zum Empfang im UKW-Bereich vorgesehenen Rundfunkgeräten bekannt. An solche Tuner wird die Anforderung gestellt, dass sie auch grössere Eingangssignale ohne Verzerrungen und Störungen, die beispielsweise durch Kreuzmodulation oder Oberwellenmischprodukte entstehen können, zu verarbeiten in der Lage sind. In diesem Zusammenhang wurde bereits vorgeschlagen, in den Weg des Hochfrequenzsignals einen viariablen Spannungsteiler einzuschalten, der aus Dioden besteht, deren Impedanz von einem Regelkreis her verändert wird, wie dies beispielsweise in der DE-OS 28 09 489 angegeben ist. Es sind aber auch bereits Tuner bekannt, deren aktive Schaltungselemente in ihrer Verstärkung geregelt werden, wozu von einem Regelkreis her ihr Arbeitspunkt verändert wird, beispielsweise in Form einer Aufwärtsregelung, wobei durch Erhöhung des Arbeitspunktstromes die Verstärkung erniedrigt wird, wie dies in der DE-PS 11 76 718 angegeben ist.

Die Erfindung hat sich zum Ziel gesetzt, einen Tuner der eingangs angeführten Gattung auf schaltungstechnisch möglichst einfache Weise so auszubilden, dass er auch relativ grosse Eingangssignale unverzerrt und ungestört verarbeiten kann, also ein gutes Grosssignalverhalten aufweist. Gemäss der Erfindung ist hierzu vorgesehen, dass das Hochfrequenzsignal dem Eingang der Mischstufe über eine gleichstrommässig vorgespannte Diode zugeführt wird, dass der Gleichstromweg für die Diode über den Emitterwiderstand
der Mischstufe geführt ist, dass die über den Emitterwiderstand der Mischstufe fliessenden Ströme des Transistors und
der Diode gleiche Flussrichtung aufweisen und dass ein Regelkreis für die Vorspannung der Diode vorgesehen ist, der in
Abhängigkeit der Amplitude des unbegrenzten Zwischenfrequenzsignals deren Vorspannung ändert, wobei sie bei zunehmender Amplitude des unbegrenzten Zwischenfrequenzsignals
zu kleineren Gleichströmen hin geregelt wird. Auf diese
Weise ist erreicht, dass das im Tuner zu verarbeitende Signal gleichzeitig auf zweifache Weise beeinflusst wird, nämlich einerseits dadurch, dass die Diode für das Hochfrequenzsignal als variabler Spannungsteiler wirksam ist und
andererseits dadurch, dass der Arbeitspunkt des Transistors
der Mischstufe sich in Abhängigkeit des über die Diode
fliessenden Gleichstroms im Sinne einer Aufwärtsregelung
ändert, wodurch auch ihre Verstärkung und Mischsteilheit geändert wird. Dadurch, dass bei einer solchen Aufwärtsregelung bei zunehmender Amplitude des unbegrenzten Zwischenfrequenzsignals der Arbeitspunkt des Transistors der Mischstufe zu höheren Strömen hin verschoben wird, wird ausserdem, wie an sich bekannt, erreicht, dass das verzerrungsfreie Verarbeiten von Signalen mit grösserer Amplitude begünstigt wird.

        Bei einem Tuner, bei dem das Hochfrequenzsignal
vom Ausgang der Hochfrequenzvorstufe über einen Kondensator
dem Emitter des Transistors der Mischstufe zugeführt wird,
wobei der Kondensator zusammen mit der wechselstrommässig
zum Bezugspotential führenden ausgangsseitigen Impedanz der
Hochfrequenzvorstufe im wesentlichen einen Kurzschluss für
das Zwischenfrequenzsignal bildet, hat sich als besonders
vorteilhaft erwiesen, wenn die Diode unmittelbar zwischen
den Kondensator und den Emitter des Transistors der Mischstufe eingeschaltet ist. Auf diese Weise ist zusätzlich zu
den bereits erwähnten Signalbeeinflussungen erreicht, dass
bei zunehmender Amplitude des unbegrenzten Zwischenfrequenzsignals, die dabei ansteigende Impedanz der Diode den Kondensator vom Emitterwiderstand wechselstrommässig entkoppelt, was zur Folge hat, dass über den für das Zwischenfrequenzsignal nicht mehr wechselstrommässig überbrückten Emitterwiderstand in der Mischstufe eine Gegenkopplung für das
Zwischenfrequenzsignal und damit eine Verringerung der Verstärkung derselben eintritt.

Weiters hat sich bei einem Tuner, bei dem der Ausgang der Hochfrequenzvorstufe durch einen Parallelresonanzkreis gebildet ist, als vorteilhaft erwiesen, wenn der Regelkreis für die Vorspannung der Diode an den Parallelresonanzkreis der Hochfrequenzvorstufe wechselstrommässig angekoppelt ist, wobei die Impedanz des Regelkreises bei zunehmender Amplitude des unbegrenzten Zwischenfrequenzsignals den
Parallelresonanzkreis zunehmend bedämpft. Durch eine solche
Bedämpfung des Parallelresonanzkreises der Hochfrequenzvorstufe erfolgt eine weitere Herabsetzung des dem Eingang
der Mischstufe zugeführten Hochfrequenzsignals, ohne dass
hierzu zusätzliche Schaltungselemente notwendig wären.

Ebenfalls als vorteilhaft hat sich erwiesen,
wenn der Regelkreis für die Vorspannung der Diode gleichstrommässig an einen den Arbeitspunkt der Hochfrequenzvorstufe bestimmenden Widerstand angekoppelt ist, wobei bei
zunehmender Amplitude des unbegrenzten Zwischenfrequenzsignals der Arbeitspunkt der Hochfrequenzvorstufe in Richtung geringerer Verstärkung derselben verschoben wird. Auf
diese Weise ist auch noch die Hochfrequenzvorstufe zur Verstärkungsregelung mitherangezogen. Hierbei kann die Änderung des Arbeitspunktes der Hochfrequenzvorstufe je nach
der gewünschten Regelungsart, einer Abwärts- oder Aufwärtsregelung, entweder zu niedereren oder höheren Strömen hin
erfolgen, wobei aber die letztere Reglungsart wieder hinsichtlich des Grosssignalverhaltens als günstiger anzusehen
ist.

Als sehr vorteilhaft hat sich auch erwiesen, wenn
der Regelkreis für die Vorspannung der Diode gleichstrommässig an den Basiskreis des Transistors der Mischstufe angekoppelt ist, wobei bei zunehmender Amplitude des unbegrenzten Zwischenfrequenzsignals der Arbeitspunkt der Mischstufe zu höheren Strömen hin verschoben wird. Auf diese Weise ist die Änderung des Arbeitspunktes der Mischstufe nicht nur von dem über die Diode und den Emitterwiderstand der Mischstufe fliessenden Strom, sondern auch von dem dem Basiskreis des Transistors zugeführten Strom abhängig, was zur Folge hat, dass grössere Änderungen des Arbeitspunktes der Mischstufe möglich sind.

Die Erfindung wird im folgenden anhand der Zeichnungen, in welchen einige Ausführungsbeispiele der Erfindung dargestellt sind, auf die sie jedoch nicht beschränkt sein soll, näher erläutert. Fig. 1 zeigt das Schaltbild eines Tuners, bei dem das Hochfrequenzsignal dem Emitter des Transistors der Mischstufe und das Oszillatorsignal dessen Basis zugeführt wird. Fig. 2 zeigt das Schaltbild eines Tuners, bei dem sowohl das Oszillatorsignal als auch das Hochfrequenzsignal sowie ein zusätzliches Regelsignal der Basis des Transistors der Mischstufe zugeführt wird. Fig. 3 zeigt das Schaltbild eines Tuners, bei dem zusätzlich auch noch die Hochfrequenzvorstufe geregelt wird.

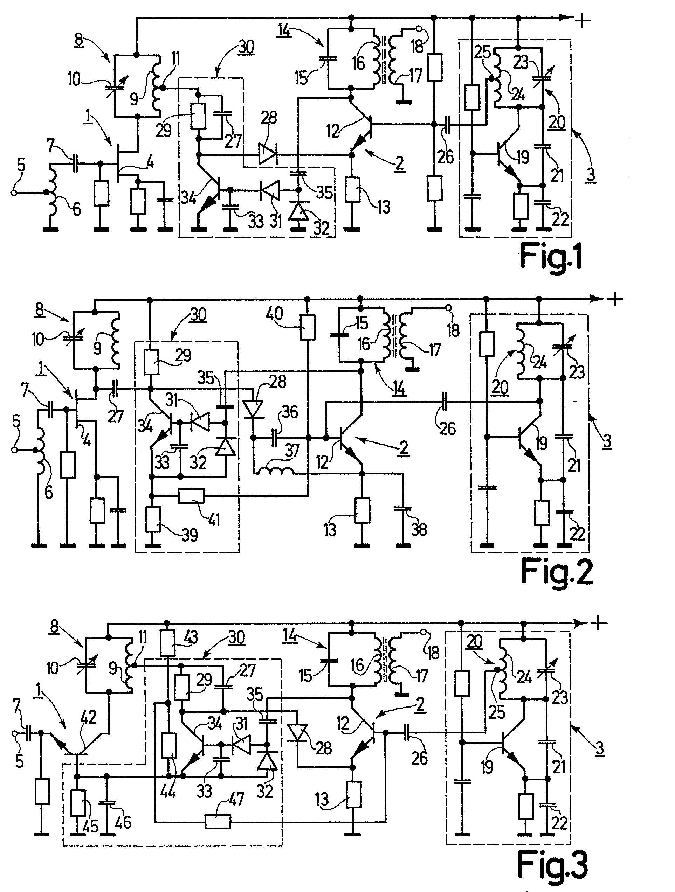

Bei dem in Fig. 1 dargestellten Tuner ist die Hochfrequenzvorstufe mit 1, die Mischstufe mit 2 und der Oszillator mit 3 bezeichnet. Die Hochfrequenzvorstufe 1 ist mit einem Feldeffekttransistor 4 aufgebaut, dessen Gateelektrode von einem Antenneneingang 5 her das Hochfrequenzsignal über einen Anpassungstransformator 6 und einen Trennkondensator 7 zugeführt wird. Ausgangsseitig weist die Hochfrequenzvorstufe 1 einen Parallelresonanzkreis 8 auf. der aus einer durch eine Spule 9 gebildeten Induktivität und einer abstimmbaren Kapazität 10 besteht. Das durch die Hochfrequenzvorstufe verstärkte Hochfrequenzsignal wird von einer Anzapfung 11 der Spule 9 abgenommen. An sich wäre es natürlich auch möglich, die Hochfrequenzvorstufe in bekannter Weise als aperiodische Verstärkerstufe auszubilden. Die Mischstufe 2 weist einen Transistor 12 auf, in dessen Emitterkreis ein Emitterwiderstand 13 und in dessen Kollektorkreis ein auf die Zwischenfrequenz abgestimmter Parallelresonanzkreis 14 aufgenommen ist. Dieser Parallelresonanzkreis 14 besteht aus einem Kondensator 15 und einer Spule 16, an die beispielsweise eine Sekundärwicklung 17 angekoppelt ist, welche den Ausgang 18 für das Zwischenfrequenzsignal bildet. Zum Aufbau des Oszillators 3 stehen im Rahmen des bekannten Standes der Technik eine Reihe von Möglichkeiten zur Verfügung. Im vorliegenden Fall ist ein in Basisgrundschaltung arbeitender Transistor 19 vorgesehen, der in seinem Kollektorkreis einen Parallelresonanzkreis 20 aufweist, von dem über einen kapazitiven Spannungsteiler 21, 22 eine Rückkopplung zum Emitter dieses Transistors hergestellt ist. Der Parallelresonanzkreis 20 weist eine abstimmbare Kapazität 23 und eine durch eine Spule 24 gebildete Induktivität auf, die mit einer Anzapfung 25 versehen ist, von der her das Oszillatorsignal über einen Kondensator 26 der Basis des die Mischstufe 2 bildenden Transistors 12 zugeführt wird.

Beim vorliegenden Ausführungsbeispiel ist vorgesehen, dass das vom Parallelresonanzkreis 8 der Hochfrequenzvorstufe 1 abgenommene Hochfrequenzsignal dem Emitter des Transistors 12 der Mischstufe 2 zugeführt wird. Dies erfolgt nun in der Weise, dass an die Anzapfung 11 der Spule 9 ein Kondensator 27 und zu diesem in Serie eine Diode 28 angeschlossen ist, die ihrerseits unmittelbar mit dem Emitter des Transistors 12 in Verbindung steht. Zur Bildung eines Gleichstromweges für die Diode 28 ist noch ein Widerstand 29 vorgesehen, der hier zum Kondensator 27 parallel geschaltet ist, so dass dieser Gleichstromweg von der Versorgungsspannung über die Spule 9, den Widerstand 29, die Diode 28 und den Emitterwiderstand 13 der Mischstufe 2 zum Bezugspotential führt. Die Polarität der Diode 28 ist dabei so gewählt, dass sie in Durchlassrichtung betrieben ist und ihr über den Emitterwiderstand 13 der Mischstufe 2 fliessender Strom die gleiche Flussrichtung aufweist, wie der Strom der vom Transistor 12 über den Emitterwiderstand 13 fliesst. Dadurch, dass die Diode 28 in Durchlassrichtung betrieben ist, weist sie eine niedere Impedanz auf, so dass das Hochfrequenzsignal vom Parallelkreis 8 über den Kondensator 27 praktisch ungehindert über die Diode 28 zum Emitter des Transistors 12 gelangt, der hier den Eingang der Mischstufe für das Hochfrequenzsignal bildet.

Zweckmässigerweise ist die Kapazität des Kondensators 27 derart gewählt, dass dieser zusammen mit der von der Anzapfung 11 der Spule 9 wechselstrommässig zum Bezugspotential führenden Impedanz des Parallelresonanzkreises 8 im wesentlichen einen Kurzschluss für das Zwischenfrequenzsignal bildet. Die vorstehend erwähnten Schaltungselemente können dabei auch so aufeinander abgestimmt sein, dass sie unmittelbar einen Saugkreis für das Zwischenfrequenzsignal ergeben. Auf diese Weise ist erreicht, dass bei sich in Durchlassrichtung befindender Diode 28 der Emitterwiderstand 13 der Mischstufe 2 für das Zwischenfrequenzsignal wechselstrommässig überbrückt ist, was bedeutet, dass die Mischstufe 2 mit hoher Verstärkung für das Zwischenfrequenzsignal arbeitet, da durch den Emitterwiderstand 13 keine Gegenkopplung erfolgt.

Um nun die Diode 28 hinsichtlich ihrer Betriebsweise beeinflussen zu können, ist ein in üblicher Weise aufgebauter Regelkreis 30 vorgesehen. Dieser Regelkreis 30 besteht aus einer durch zwei Dioden 31 und 32 gebildeten Gleichrichterschaltung, an die ein Glättungskondensator 33 angeschlossen ist, zu dem seinerseits die Basis-Emitterstrecke eines das Regelsignal verstärkenden Transistors 34 parallel liegt, dessen Kollektor an den Verbindungspunkt des Widerstandes 29 mit der Diode 28 angeschlossen ist, so dass der Widerstand 29 auch als Arbeitswiderstand für den Transistor 34 wirksam ist. Diesem Regelkreis 30 wird als Eingangssignal das unbegrenzte Zwischenfrequenzsignal zugeführt, was im vorliegenden Fall dadurch geschieht, dass die Gleichrichteranordnung des Regelkreises über einen Kondensator 35 an den Kollektor des Transistors 12 angekoppelt ist. An sich könnte natürlich das dem Regelkreis zugeführte Zwischenfrequenzsignal auch von einer der Mischstufe 2 nachfolgenden Zwischenfrequenzverstärkerstufe abgenommen werden, soferne das Zwischenfrequenzsignal an dieser Stufe noch keiner Begrenzung unterliegt. Ebenso könnte der Gleichrichteranordnung des Regelkreises eine entsprechende Vorspannung zugeführt werden, um den Einsatz der Regelung, je nachdem was gewünscht ist, entweder zu verzögern oder zu beschleunigen.

Beispielsweise für eine Beschleunigung des Regeleinsatzes könnte die Gleichrichteranordnung des Regelkreises gleichstrommässig an den Emitterwiderstand 13 des Transistors 12 angekoppelt werden.

Die Wirkungsweise dieser Schaltungsanordnung ist nun wie folgt. Bei einem entsprechend kleinen Hochfrequenzsignal und einem dementsprechend auch kleinen Zwischenfrequenzsignal ist der Regelkreis 30 nicht in Funktion, sein Transistor 34 ist nicht leitend und dementsprechend die Diode 28 in Durchlassrichtung gleichstrommässig vorgespannt und damit niederohmig, so dass das Hochfrequenzsignal, wie bereits erwähnt, praktisch ungeschwächt der Mischstufe 2 zugeführt wird. Der Transistor 12 der Mischstufe 2 befindet sich dabei in einem Arbeitspunkt, der eine optimale Mischsteilheit und hohe Verstärkung für das Zwischenfrequenzsignal gewährleistet, wobei auch durch die im Zusammenhang mit dem Kondensator 27 stehende wechselstrommässige Entkopplung des Emitterwiderstandes 13 keine Gegenkopplung für das Zwischenfrequenzsignal vorliegt. Bei zunehmender Amplitude des Hochfrequenzsignals wird auch die Amplitude des Zwischenfrequenzsignals grösser, was zur Folge hat, dass im Regelkreis 30 eine Gleichrichtung des Zwischenfrequenzsignals erfolgt, was weiters zur Folge hat, dass der Transistor 34 in zunehmender Weise leitend wird, wodurch sein über den Widerstand 29 fliessender Kollektorstrom ansteigt, was bedeutet, dass der Spannungsabfall am Widerstand 29 grösser wird, was wiederum zur Folge hat, dass der Gleichstrom durch die Diode 28 kleiner wird. Ein kleinerer Strom durch die Diode 28 bedeutet aber, dass ihre Impedanz ansteigt, was zur Folge hat, dass die Diode 28 zusammen mit der Eingangsimpedanz der Mischstufe 2 in zunehmender Weise für das Hochfrequenzsignal als Spannungsteiler wirksam wird, so dass der Mischstufe 2 entsprechend weniger Hochfrequenzsignal zugeführt wird. Ein sinkender Gleichstrom durch die Diode 28 hat dadurch, dass er auch über den Emitterwiderstand 13 der Mischstufe 2 fliesst, weiters zur Folge, dass der Spannungsabfall am Widerstand 13 kleiner wird, was aber bedeutet, dass der Strom durch den Transistor 12 ansteigt und damit der Transistor 12

im Sinne einer Aufwärtsregelung auf Arbeitspunkte verschoben wird, die eine geringere Mischsteilheit haben, wodurch nur weniger Zwischenfrequenzsignal erzeugt wird. Bei grösser werdendem Strom durch den Transistor 12 sinkt aber auch dessen Verstärkungsfaktor, so dass auch dadurch eine Herabsetzung des Zwischenfrequenzsignals erfolgt. Dadurch, dass die Impedanz der Diode 28 zunimmt, tritt hier aber noch ein weiterer Effekt ein, nämlich dahingehend, dass die wechselstrommässige Entkopplung des Emitterwiderstandes 13 für das Zwischenfrequenzsignal immer geringer wird, weil die Impedanz der Diode 28 zwischen dem Emitterwiderstand 13 und dem Kondensator 27 und der wechselstrommässig zum Bezugspotential führenden Impedanz des Parallelresonanzkreises 8 liegt. Dies bedeutet aber, dass der Emitterwiderstand 13 in zunehmender Weise eine Gegenkopplung für das Zwischenfrequenzsignal bildet und daher auch demzufolge die Verstärkung des Zwischenfrequenzsignals in der Mischstufe 2 sinkt.

Wie ersichtlich, treten somit, wie bisher beschrieben, drei Effekte auf, die bei zunehmendem Hochfrequenzsignal eine Signalabschwächung bewirken, nämlich eine Spannungsteilung durch die Diode 28, eine Aufwärtsregelung des Transistors 12 der Mischstufe und eine zunehmende Gegenkopplung des Zwischenfrequenzsignals. Durch die Aufwärtsregelung der Mischstufe wird dabei ausserdem erreicht, dass sie auf Arbeitspunkte verschoben wird, in denen grössere Signale besser unverzerrt verarbeitet werden können, dies bei sinkender Mischverstärkung und sinkender Verstärkung. Auf diese Weise wird ein sehr gutes Grosssignalverhalten des Tuners erreicht.

Gemäss der vorliegenden Schaltungsanordnung tritt aber noch ein weiterer Effekt ein, der das Grosssignalverhalten des Tuners verbessert, und zwar dadurch, dass der Regelkreis 30 auch an den Parallelresonanzkreis 8 der Hochfrequenzvorstufe wechselstrommässig angekoppelt ist. Je mehr der Transistor 34 leitend wird, um so geringer wird seine Impedanz der Kollektor-Emitterstrecke. Da diese Impedanz aber über den Kondensator 27 wechselstrommässig für das Hochfrequenzsignal unmittelbar an der Anzapfung 11 der Spule 9 liegt, bedämpft sie auch den Parallelresonanzkreis 8, was zur Folge hat, dass die Verstärkung des Hochfrequenzsignals in der Hochfrequenzvorstufe und die Resonanzüberhöhung im Parallelresonanzkreis für das Hochfrequenzsignal sinkt. Mit einer solchen Bedämpfung wird daher eine weitere Verbesserung des Grosssignalverhaltens des Tuners erreicht. Der Grad der Bedämpfung des Parallelresonanzkreises 8 richtet sich dabei in bekannter Weise danach, wie die Anzapfung 11 in bezug auf die Spule 9 gewählt ist. Falls erwünscht, könnte die Auskopplung des Hochfrequenzsignals auch unmittelbar vom gesamten Parallelresonanzkreis 8 erfolgen, wobei dann der Regelkreis 30 unmittelbar wechselstrommässig an den Parallelresonanzkreis 8 angekoppelt wäre. Ist aber eine Bedämpfung des Parallelresonanzkreises, beispielsweise aus Gründen der Selektivität, nicht erwünscht, so kann der Regelkreis durch Einfügung einer Drossel in Serie zum Kollektor des Transistors 34 wechselstrommässig vom Parallelresonanzkreis entkoppelt werden.

Das Ausführungsbeispiel nach Fig. 2 zeigt die Anwendung der erfindungsgemässen Massnahmen bei einer gegenüber dem Ausführungsbeispiel nach Fig. 1 anders gewählten Betriebsweise der Mischstufe 2. Hier wird nämlich sowohl das Oszillatorsignal als auch das Hochfrequenzsignal der Basis der Transistors 12 der Mischstufe 2 zugeführt. Die Auskopplung dieser Signale erfolgt hier hochohmig unmittelbar von den Parallelresonanzkreisen 8 bzw. 20 her über die Kondensatoren 27 bzw. 26. In Serie zum Kondensator 27 liegt wieder die Diode 28, die ihrerseits hier über einen Kondensator 36 mit der Basis des Transistors 12 wechselstrommässig verbunden ist. Um auch im vorliegenden Fall zu erreichen, dass der über die Diode 28 fliessende Gleichstrom auch über den Emitterwiderstand 13 der Mischstufe 2 fliesst, ist die Diode 28 weiters gleichstrommässig über eine Spule 37 mit dem Emitter des Transistors 12 verbunden. Unter anderem hat das Einfügen einer derartigen Spule 37 zur Folge, dass hier der Kondensator 27 zusammen mit der wechselstrommässig zum Bezugspotential führenden Impedanz des Parallelresonanzkreises 8 nicht mehr zur Bildung eines Kurzschlusses für das Zwischenfrequenzsignal ausgenützt werden kann. Damit aber auch hier die Basis-Emitterstrecke des Transistors 12 für das Zwischenfrequenzsignal niederohmig abgeschlossen ist, was bekanntlich für
eine einwandfreie Funktionsweise der Mischstufe notwendig
ist, ist die Kapazität des Kondensators 36 und die Induktivität der Spule 37 so gewählt, dass sie zusammen einen Saugkreis für das Zwischenfrequenzsignal bilden, wobei dann
weiters der Emitterwiderstand 13 des Transistors 12 durch
Parallelschaltung eines Kondensators 38 für das Zwischenfrequenzsignal wechselstrommässig überbrückt ist.

        Der Regelkreis 30 zur Beeinflussung der Betriebsweise der Diode 28 ist analog zum Ausführungsbeispiel nach
Fig. 1 aufgebaut. Beim vorliegenden Ausführungsbeispiel
ist jedoch zusätzlich vorgesehen, dass der Regelkreis 30
gleichstrommässig auch an den Basiskreis des Transistors 12
der Mischstufe 2 angekoppelt ist, wobei bei zunehmender Amplitude des unbegrenzten Zwischenfrequenzsignals der Arbeitspunkt der Mischstufe 2 zu höheren Strömen hin verschoben
wird. Um dies zu erreichen, ist in Serie zum Emitter des
Transistors 34 ein zum Bezugspotential führender Widerstand
39 eingeschaltet und der durch die Widerstände 40 und 41 gebildete Spannungsteiler zur Vorspannung der Basis des Transistors 12 mit dem Widerstand 41 an den Verbindungspunkt des
Emitters des Transistors 34 mit dem Widerstand 39 gelegt.
Auf diese Weise ist erreicht, dass im Zuge der Regelung bei
zunehmendem Strom durch den Transistor 34 der Spannungsabfall am Widerstand 39 ansteigt, was zur Folge hat, dass dann
die an der Basis des Transistors 12 wirksame Vorspannung den
Arbeitspunkt des Transistors 12 zu höheren Strömen hin verschiebt. Wie ersichtlich, erfolgt dabei die von der Basis
des Transistors 12 her bewirkte Aufwärtsregelung in übereinstimmender Weise mit der durch den über die Diode 28, die
Spule 37 und den Emitterwiderstand 13 fliessenden Gleichstrom
bedingten Aufwärtsregelung des Transistors 12, da der durch
die Diode 28 fliessende Gleichstrom wieder bei zunehmendem
Strom durch den Transistor 34 kleiner wird, was eine Verringerung des Spannungsabfalles am Emitterwiderstand 13 bewirkt. Auf diese Weise wird demnach der Transistor 12 sowohl
von seiner Emitterseite als auch von seiner Basisseite her im Sinne einer Aufwärtsregelung beeinflusst, wodurch insgesamt gesehen ein grösserer Regelbereich für die Mischstufe 2 erhalten wird.

Die Wirkungsweise der Diode 28 als Spannungsteiler im Zusammenhang mit der Eingangsimpedanz der Mischstufe 2 ist wieder analog wie beim Ausführungsbeispiel nach Fig. 1. Beim vorliegenden Ausführungsbeispiel tritt jedoch bei zunehmend grösser werdender Impedanz der Diode 28 keine Gegenkopplung für das Zwischenfrequenzignal in der Mischstufe 2 ein, weil hier der Emitterwiderstand 13 der Mischstufe für das Zwischenfrequenzsignal ständig wechselstrommässig entkoppelt ist. Wie beim Ausführungsbeispiel nach Fig. 1 ist aber auch hier der Regelkreis 30 an den Parallelresonanzkreis 8 der Hochfrequenzvorstufe 1 wechselstrommässig angekoppelt, so dass auch hier bei zunehmender Regelung eine Bedämpfung dieses Parallelresonanzkreises erfolgt.

Beim Ausführungsbeispiel nach Fig. 2 bewirken somit bei zunehmendem Hochfrequenzsignal drei Massnahmen eine Signalabschwächung, nämlich die Spannungsteilung durch die Diode 28, die Aufwärtsregelung des Transistors 12 der Mischstufe 2 und die Bedämpfung des Parallelresonanzkreises 8 der Hochfrequenzvorstufe 1 durch den Regelkreis 30. Auf diese Weise wird wieder ein gutes Grosssignalverhalten des Tuners erreicht.

Beim Ausführungsbeispiel nach Fig. 3 ist wieder eine Betriebsweise der Mischstufe 2 wie beim Ausführungsbeispiel nach Fig. 1 vorgesehen, bei der das Hochfrequenzsignal über die Diode 28 dem Emitter des Transistors 12 und das Oszillatorsignal über einen Kondensator 26 der Basis des Transistors 12 zugeführt wird. Auch der zur Beeinflussung der Betriebsweise der Diode 28 vorgesehene Regelkreis 30 ist analog zum Ausführungsbeispiel nach Fig. 1 aufgebaut. Beim Ausführungsbeispiel nach Fig. 3 ist jedoch zusätzlich noch eine Regelung der Hochfrequenzvorstufe 1 und weiters, wie beim Ausführungsbeispiel nach Fig. 2, wieder eine zusätzliche Regelung des Transistors 12 der Mischstufe 2 von dessen Basis her vorgesehen.

Beim vorliegenden Ausführungsbeispiel ist die Hochfrequenzvorstufe 1 durch einen in Basisgrundschaltung betriebenen Transistor 42 gebildet, dessen Emitter das Hochfrequenzsignal vom Antenneneingang 5 über einen Kondensator 7 zugeführt wird. In den Kollektorkreis des Transistors 42 ist der Parallelresonanzkreis 8 aufgenommen. Die Arbeitspunkteinstellung des Transistors 42 erfolgt basisseitig von einem durch die Widerstände 43, 44 und 45 gebildeten Spannungsteiler, wobei seine Basis an den Verbindungspunkt der Widerstände 44 und 45 angeschlossen ist. Zur wechselstrommässigen Entkopplung ist der Widerstand 45 mit einem Kondensator 46 überbrückt. Um nun eine Regelung der Hochfrequenzvorstufe zu bewirken, ist der Regelkreis 30 gleichstrommässig an einen den Arbeitspunkt der Hochfrequenzvorstufe bestimmenden Widerstand angekoppelt, wozu im vorliegenden Fall der Emitter des Transistors 34 an den Verbindungspunkt der Widerstände 44 und 45 angeschlossen ist. Beim Einsetzen der Regelung steigt wieder der Strom durch den Transistor 34, was zur Folge hat, dass sich der Spannungsabfall am Widerstand 45 vergrössert, wodurch der Arbeitspunkt des Transistors 42 der Hochfrequenzvorstufe zu höheren Strömen hin verschoben wird. Auf diese Weise wird eine Aufwärtsregelung der Hochfrequenzvorstufe erreicht, die ein Absinken ihrer Verstärkung zur Folge hat. Falls erwünscht, könnte natürlich auch eine Abwärtsregelung der Hochfrequenzvorstufe 1 vorgesehen werden, was dadurch geschehen kann, dass der Emitter des Transistors 34 gleichstrommässig an den Emitterwiderstand des Transistors 42 angekoppelt wird.

Auch die Arbeitspunkteinstellung des Transistors 12 der Mischstufe 2 wird vom Spannungsteiler 43, 44 und 45 abgeleitet, dadurch, dass dessen Basis über einen Widerstand 47 an den Verbindungspunkt der Widerstände 43 und 44 angeschlossen ist. Auf diese Weise ist auch der beim Einsetzen der Regelung durch den ansteigenden Strom des Transistors 34 am Widerstand 45 auftretende Spannungsabfall massgebend für die Beeinflussung der Vorspannung der Basis des Transistors 12 der Mischstufe 2, wobei sein Arbeitspunktstrom im Sinne einer Aufwärtsregelung vergrössert wird. Diese basisseitige Regelung des Transistors 12 erfolgt wieder in übereinstimmender Weise mit der emitterseitigen Regelung, die durch den über die Diode 28 und den Emitterwiderstand 13 fliessenden Gleichstrom bewirkt wird, wodurch insgesamt gesehen wieder ein grösserer Regelbereich für die Mischstufe 12 erhalten wird.

Im übrigen ist die Funktionsweise dieser Schaltungsanordnung analog zu derjenigen des Ausführungsbeispiels nach Fig. 1. Für eine Signalabschwächung bei zunehmendem Hochfrequenzsignal sind hier aber fünf Faktoren massgebend, nämlich die Spannungsteilung durch die Diode 28, die Aufwärtsregelung des Transistors 12 der Mischstufe 2, die zunehmende Gegenkopplung des Zwischenfrequenzsignals durch den Emitterwiderstand 13 der Mischstufe 2, die Bedämpfung des Parallelresonanzkreises 8 der Hochfrequenzvorstufe 1 durch den Regelkreis 30 und schliesslich die Aufwärtsregelung des Transistors 42 der Hochfrequenzvorstufe 1. Auf diese Weise wird wieder ein sehr gutes Grosssignalverhalten des Tuners erreicht.

Wie aus vorstehendem ersichtlich ist, gibt es eine Reihe von Abwandlungen der beschriebenen Ausführungsbeispiele, ohne dass dabei der Rahmen der Erfindung verlassen wird. Dies gilt insbesondere für die Ausgestaltung und Betriebsweise der einzelnen Stufen des Tuners sowie für die Art und Weise ihrer Regelung. In diesem Zusammenhang sei beispielsweise erwähnt, dass die Auskopplung des Hochfrequenzsignals vom Parallelresonanzkreis der Hochfrequenzvorstufe natürlich nicht zwingend kapazitiv erfolgen muss, sondern es kann dies auch induktiv geschehen, indem die Spule 9 des Parallelresonanzkreises mit einer Sekundärwicklung versehen wird. Im weiteren kann die Diode 28 eventuell als Basis-Emitter Diode eines, z.B. mit dem Transistor 12 der Mischstufe 2 in katodengekoppelte Gegentaktstufe (long-tailed pair) Konfiguration geschaltete, Transistors gebildet sein.

PATENTANSPRÜCHE:

1.        Tuner mit einer Hochfrequenzvorstufe, von deren Ausgang das Hochfrequenzsignal einem Eingang einer Mischstufe zugeführt wird, der zusätzlich ein Oszillatorsignal eines Oszillators zugeführt wird und die durch einen Transistor gebildet ist, der in seinem Emitterkreis einen Emitterwiderstand aufweist und von dessen Kollektorkreis das Zwischenfrequenzsignal ausgekoppelt wird, dadurch gekennzeichnet, dass das Hochfrequenzsignal dem Eingang der Mischstufe über eine gleichstrommässig vorgespannte Diode zugeführt wird, dass der Gleichstromweg für die Diode über den Emitterwiderstand der Mischstufe geführt ist, dass die über den Emitterwiderstand der Mischstufe fliessenden Ströme des Transistors und der Diode gleiche Flussrichtung aufweisen und dass ein Regelkreis für die Vorspannung der Diode vorgesehen ist, der in Abhängigkeit der Amplitude des unbegrenzten Zwischenfrequenzsignals deren Vorspannung ändert, wobei sie bei zunehmender Amplitude des unbegrenzten Zwischenfrequenzsignals zu kleineren Gleichströmen hin geregelt wird.

2.        Tuner nach Anspruch 1, bei dem das Hochfrequenzsignal vom Ausgang der Hochfrequenzvorstufe über einen Kondensator dem Emitter des Transistors der Mischstufe zugeführt wird, wobei der Kondensator zusammen mit der wechselstrommässig zum Bezugspotential führenden ausgangsseitigen Impedanz der Hochfrequenzvorstufe im wesentlichen einen Kurzschluss für das Zwischenfrequenzsignal bildet, dadurch gekennzeichnet, dass die Diode unmittelbar zwischen den Kondensator und den Emitter des Transistors der Mischstufe eingeschaltet ist.

3.        Tuner nach Anspruch 1 oder 2, bei dem der Ausgang der Hochfrequenzvorstufe durch einen Parallelresonanzkreis gebildet ist, dadurch gekennzeichnet, dass der Regelkreis für  die Vorspannung der Diode an den Parallelresonanzkreis der Hochfrequenzvorstufe wechselstrommässig angekoppelt ist,

0098670

wobei die Impedanz des Regelkreises bei zunehmender Amplitude des unbegrenzten Zwischenfrequenzsignals den Parallelresonanzkreis zunehmend bedämpft.

4. Tuner nach einem der vorhergehenden Ansprüche, dadurch gekennzeichnet, dass der Regelkreis für die Vorspannung der Diode gleichstrommässig an einen den Arbeitspunkt der Hochfrequenzvorstufe bestimmenden Widerstand angekoppelt ist, wobei bei zunehmender Amplitude des unbegrenzten Zwischenfrequenzsignals der Arbeitspunkt der Hochfrequenzvorstufe in Richtung geringerer Verstärkung derselben verschoben wird.

5. Tuner nach einem der vorhergehenden Ansprüche, dadurch gekennzeichnet, dass der Regelkreis für die Vorspannung der Diode gleichstrommässig an den Basiskreis des Transistors der Mischstufe angekoppelt ist, wobei bei zunehmender Amplitude des unbegrenzten Zwischenfrequenzsignals der Arbeitspunkt der Mischstufe zu höheren Strömen hin verschoben wird.

0098670

1/1

Fig.1

Fig.2

Fig.3

PHO 82-508